(19) **Europäisches Patentamt**
**European Patent Office**
**Office européen des brevets**

(11) **EP 4 282 609 A1**

(12) **EUROPEAN PATENT APPLICATION**
published in accordance with Art. 153(4) EPC

(43) Date of publication:
**29.11.2023 Bulletin 2023/48**

(21) Application number: **22742718.4**

(22) Date of filing: **25.01.2022**

(51) International Patent Classification (IPC):
*B29B 15/10* $^{(2006.01)}$      *B29C 45/00* $^{(2006.01)}$
*C08J 3/20* $^{(2006.01)}$      *C08K 7/02* $^{(2006.01)}$
*C08K 7/04* $^{(2006.01)}$      *C08L 23/00* $^{(2006.01)}$
*C08L 77/00* $^{(2006.01)}$      *C08L 101/00* $^{(2006.01)}$
*C08J 5/00* $^{(2006.01)}$      *B29C 70/06* $^{(2006.01)}$
*B29C 70/42* $^{(2006.01)}$      *C08K 3/013* $^{(2018.01)}$
*C08K 3/04* $^{(2006.01)}$

(52) Cooperative Patent Classification (CPC):
**B29B 15/10; B29C 45/00; B29C 70/06;**
**B29C 70/42; C08J 3/20; C08J 5/00; C08K 3/013;**
**C08K 3/04; C08K 7/02; C08K 7/04; C08L 23/00;**
**C08L 77/00; C08L 101/00;** B29K 2101/12;
B29K 2105/14

(86) International application number:
**PCT/JP2022/002549**

(87) International publication number:
**WO 2022/158599 (28.07.2022 Gazette 2022/30)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **25.01.2021   JP 2021009386**
**25.01.2021   JP 2021009387**
**23.06.2021   JP 2021104364**

(71) Applicant: **Sekisui Techno Molding Co., Ltd.**
**Minato-ku, Tokyo 105-8566 (JP)**

(72) Inventors:
• SUENAGA, Yuusuke
  Toyohashi-shi, Aichi 441-8123 (JP)
• MATSUMURA, Ryuuji
  Toyohashi-shi, Aichi 441-8123 (JP)
• MASUDA, Takuya
  Toyohashi-shi, Aichi 441-8123 (JP)
• NAKAJIMA, Nami
  Mishima-gun, Osaka 618-0021 (JP)
• SHINOHARA, Takamichi
  Mishima-gun, Osaka 618-0021 (JP)

(74) Representative: **Ter Meer Steinmeister & Partner**
**Patentanwälte mbB**
**Nymphenburger Straße 4**
**80335 München (DE)**

(54) **RESIN COMPOSITION, RESIN MOLDED ARTICLE, AND METHOD FOR PRODUCING SAME**

(57)    Provided is a resin composition having excellent electromagnetic wave shielding properties. A resin composition containing: a thermoplastic resin (A); graphite (B); and two or more kinds of carbon black (C), the two or more kinds of carbon black (C) including a first carbon black (C-1) having a BET specific surface area of 600 $m^2$/g or more and a second carbon black (C-2) having a BET specific surface area of less than 600 $m^2$/g.

EP 4 282 609 A1

**Description**

**TECHNICAL FIELD**

The present invention relates to a resin composition, and a resin molded article and a method for producing the resin molded article which uses the resin composition.

**BACKGROUND ART**

Conventionally, a metal plate, a resin molded article having thermal conductivity, or the like is used for a casing of a communication device or an electronic device, such as a security camera or a smart meter, used indoors or outdoors, a heat dissipation chassis of multi-information display, such as a car navigation system or a smart meter, or an in-vehicle camera, an LED heat dissipation heat sink, or a heat dissipation plate of SoC, GDC, or the like. SoC refers to "System-on-a-chip" and GDC refers to "Graphics Display Controller".

Patent Document 1 below discloses a molded product obtained by molding a resin compound containing a thermoplastic resin, graphite, and carbon black. Patent Document 1 describes that it is preferable to contain 20 to 80 wt% of graphite with respect to the entire resin compound. It is also described that it is preferable to contain 1 to 30 wt% of carbon black with respect to the entire resin compound.

**Related Art Document**

**Patent Document**

Patent Document 1: WO 2018/143224 A

**SUMMARY OF THE INVENTION**

**PROBLEMS TO BE SOLVED BY THE INVENTION**

In recent years, with an increase in speed of a CPU, a resin molded article having higher electromagnetic wave shielding properties than before is required.

However, when the filling amount of the conductive filler such as carbon black is increased in order to enhance conductivity in the production of the resin molded article as described in Patent Document 1, there is a problem in that fluidity in a molding step by injection molding or the like at the time of production is reduced, and consequently moldability is reduced.

An object of the present invention is to provide a resin composition having excellent electromagnetic wave shielding properties, and a resin molded article and a method for producing the resin molded article which uses the resin composition.

**MEANS FOR SOLVING THE PROBLEMS**

A resin composition according to a first invention of the present application contains: a thermoplastic resin (A); graphite (B); and two or more kinds of carbon black (C), the two or more kinds of carbon black (C) including a first carbon black (C-1) having a BET specific surface area of 600 $m^2$/g or more and a second carbon black (C-2) having a BET specific surface area of less than 600 $m^2$/g.

In a specific aspect of the resin composition according to the first invention of the present application, with respect to 100 parts by weight of the thermoplastic resin (A), a content of the first carbon black (C-1) is 5 parts by weight or more and 50 parts by weight or less, a content of the second carbon black (C-2) is 5 parts by weight or more and 50 parts by weight or less, and a content of the entire carbon black (C) is 15 parts by weight or more and 90 parts by weight or less.

In another specific aspect of the resin composition according to the first invention of the present application, a DBP oil absorption amount of the first carbon black (C-1) is 250 ml/100 g or more, and a DBP oil absorption amount of the second carbon black (C-2) is less than 250 ml/100 g.

In still another specific aspect of the resin composition according to the first invention of the present application, an ash content of each of the two or more kinds of carbon black (C) is 1% or less.

In still another specific aspect of the resin composition according to the first invention of the present application, the graphite (B) is plate-like graphite.

In still another specific aspect of the resin composition according to the first invention of the present application, a volume average particle size of the graphite (B) is 5 um or more and 500 um or less.

In still another specific aspect of the resin composition according to the first invention of the present application, a content of the graphite (B) is 50 parts by weight or more and 300 parts by weight or less with respect to 100 parts by weight of the thermoplastic resin (A).

In still another specific aspect of the resin composition according to the first invention of the present application, the thermoplastic resin (A) is at least one resin of an olefin-based resin and a nylon-based resin.

In still another specific aspect of the resin composition according to the first invention of the present application, a specific volume resistivity is $1.0 \times 10^5$ Ω·cm or less.

A resin composition according to a second invention of the present application contains: a thermoplastic resin (A); graphite (B); and carbon black (D), when the resin composition in a molten state is filled in a mold from a direction orthogonal to a thickness direction of a resulting resin molded article and molded to obtain a resin molded article of 100 mm in length × 100 mm in width × 2 mm in thickness, a relaxation time of an L component being 1.3 msec or less when a free induction decay curve of spin-spin relaxation of $^1$H obtained by measuring the resin molded article using pulsed NMR at 125°C by Hahn Echo method is subjected to waveform separation into three curves respectively derived from three components of an S component, an M component, and an L component in ascending order of relaxation time by a least-squares method.

In a specific aspect of the resin composition according to the second invention of the present application, a ratio (L component/(S component + M component + L component)) of the L component to a sum of the S component, the M component, and the L component is 10% or less.

In another specific aspect of the resin composition according to the second invention of the present application, a ratio (L component/(S component + M component + L component)) of the L component to a sum of the S component, the M component, and the L component is 4% or more.

In still another specific aspect of the resin composition according to the second invention of the present application, the graphite (B) is plate-like graphite.

In still another specific aspect of the resin composition according to the second invention of the present application, the thermoplastic resin (A) includes an olefin-based resin.

Hereinafter, the first invention and the second invention of the present application may be collectively referred to as the present invention.

In still another specific aspect of the resin composition according to the present invention, when the resin composition in a molten state is filled in a mold from a direction orthogonal to a thickness direction of a resulting resin molded article and molded to obtain a resin molded article of 100 mm in length × 100 mm in width × 2 mm in thickness, an electromagnetic wave shielding effect of the resin molded article at a frequency of any of 3 GHz, 25 GHz, 50 GHz, and 75 GHz is 20 dB or more.

In still another specific aspect of the resin composition according to the present invention, when the resin composition in a molten state is filled in a mold from a direction orthogonal to a thickness direction of a resulting resin molded article and molded to obtain a resin molded article of 100 mm in length × 100 mm in width × 2 mm in thickness, a thermal conductivity in an in-plane direction of the resin molded article is 1 W/(m·K) or more.

A resin molded article according to the present invention is a molded article of the resin composition configured according to the present invention.

In a specific aspect of the resin molded article according to the present invention, the resin molded article contains a fiber.

In another specific aspect of the resin molded article according to the present invention, a specific volume resistivity is $1.0 \times 10^5$ Ω·cm or less.

A method for producing a resin molded article according to the present invention includes: a step of mixing the resin composition configured according to the present invention and a composite body (E) containing a thermoplastic resin and a fiber to obtain a mixture; and a step of molding the mixture to obtain a resin molded article.

## EFFECT OF THE INVENTION

According to the present invention, it is possible to provide a resin composition having excellent electromagnetic wave shielding properties, and a resin molded article and a method for producing the resin molded article which uses the resin composition.

## BRIEF DESCRIPTION OF DRAWINGS

[Fig. 1] Fig. 1 is a schematic perspective view illustrating a heat dissipation chassis.

[Fig. 2] Fig. 2 is a schematic perspective view illustrating a heat dissipation casing.
[Fig. 3] Fig. 3 is a schematic perspective view illustrating a heat sink shape.

## MODES FOR CARRYING OUT THE INVENTION

Hereinafter, details of the present invention will be described.

[Resin composition of first invention]

A resin composition of the first invention of the present application contains a thermoplastic resin (A), graphite (B), and two or more kinds of carbon black (C). Each of the two or more kinds of carbon black (C) includes a first carbon black (C-1) having a BET specific surface area having 600 $m^2/g$ or more and a second carbon black (C-2) having a BET specific surface area having less than 600 $m^2/g$.

The BET specific surface area can be measured from an adsorption isotherm of nitrogen in accordance with a BET method. As a measuring device, for example, Product No. "NOVA touch LX2" manufactured by Anton Paar GmbH can be used.

Since the resin composition of the first invention contains a thermoplastic resin (A), graphite (B), and two or more kinds of specific carbon black (C), the resin composition is excellent in both of electromagnetic wave shielding properties and moldability.

Conventionally, when the filling amount of the conductive filler such as carbon black is increased in order to enhance conductivity in the production of the resin molded article, there is a problem in that fluidity in a molding step by injection molding or the like at the time of production is reduced, and consequently moldability is reduced.

The present inventors have focused on the BET specific surface areas of the first carbon black (C-1) and the second carbon black (C-2) in the resin composition containing the thermoplastic resin (A), the graphite (B), and the two or more kinds of carbon black (C). In particular, the present inventors have found that both the electromagnetic wave shielding properties and the moldability of the resin composition can be enhanced by using each of the two or more kinds of carbon black (C) including the first carbon black (C-1) having a BET specific surface area of 600 $m^2/g$ or more and the second carbon black (C-2) having a BET specific surface area of less than 600 $m^2/g$.

Hereinafter, each component of the resin composition will be described in detail.

(Thermoplastic resin (A))

The thermoplastic resin is not particularly limited, and a known thermoplastic resin can be used. Specific examples of the thermoplastic resin include polyolefins, polystyrenes, polyacrylates, polymethacrylates, polyacrylonitriles, polyesters, polyamides, polyurethanes, polyethersulfones, polyetherketones, polyimides, polydimethylsiloxanes, polycarbonates, and copolymers containing at least two of these. These thermoplastic resins may be used alone or in combination of two or more thereof. The thermoplastic resin is preferably a resin having a high elastic modulus. Polyolefins (olefin-based resin) and polyamides (nylon-based resin) are more preferable because they are inexpensive and easy to mold under heating.

The polyolefins are not particularly limited, and a known polyolefin can be used. Specific examples of the polyolefins include a polyethylene which is an ethylene homopolymer, and polyethylene-based resins such as an ethylene-$\alpha$-olefin copolymer, an ethylene-(meth)acrylic acid copolymer, an ethylene-(meth)acrylic acid ester copolymer, and an ethylene-vinyl acetate copolymer. The polyolefin may be polypropylene which is a propylene homopolymer, a polypropylene-based resin such as a propylene-$\alpha$-olefin copolymer, polybutene which is a butene homopolymer, or a homopolymer or copolymer of a conjugated diene such as butadiene or isoprene. These polyolefins may be used alone or in combination of two or more thereof. From the viewpoint of further enhancing heat resistance and elastic modulus, the polyolefin is preferably polypropylene.

The polyolefin (olefin-based resin) preferably contains an ethylene component. The content of the ethylene component is preferably 5 mass% to 40 mass%. When the content of the ethylene component is within the above range, the heat resistance can be further enhanced while the impact resistance of the resin molded article is further enhanced.

The MFR of the thermoplastic resin measured in accordance with JIS K7210 is preferably 10 g/10 min or more and more preferably 30 g/10 min or more, and is preferably 200 g/10 min or less and more preferably 150 g/10 min or less. When the MFR is within the above range, the fluidity of the thermoplastic resin can be further enhanced.

The content of the thermoplastic resin in the resin composition is preferably 20 wt% or more and more preferably 25 wt% or more, and is preferably 65 wt% or less and more preferably 60 wt% or less. When the content of the thermoplastic resin is within the above range, the moldability of the resin composition can be further enhanced.

(Graphite (B))

The graphite is not particularly limited, and is preferably plate-like graphite. The plate-like graphite is not particularly limited as long as it is plate-like graphite, and for example, graphite, flaked graphite, graphene, or the like can be used. From the viewpoint of further enhancing thermal conductivity and flame retardancy, graphite or flaked graphite is preferable. These may be used alone or in combination of two or more thereof. In the first invention, as the plate-like graphite, for example, scale-like graphite can be used. From the viewpoint of further enhancing the flame retardancy, expanded graphite may be used.

The flaked graphite is obtained by peeling treatment of the original graphite, and refers to a graphene sheet laminate thinner than the original graphite. The peeling treatment for forming flaked graphite is not particularly limited, and either a mechanical peeling method using a supercritical fluid or the like or a chemical peeling method using an acid may be used. The number of laminated graphene sheets in the flaked graphite may be any number as long as it is smaller than that of the original graphite, and is preferably 1000 layers or less, more preferably 500 layers or less, and further preferably 200 layers or less.

In the first invention, the volume average particle size of the plate-like graphite is preferably 5 pm or more, more preferably 30 um or more, and further preferably 60 um or more, and is preferably 500 um or less, more preferably 350 um or less, and further preferably 300 um or less. When the volume average particle size of the plate-like graphite is the lower limit value or more, the electromagnetic wave shielding properties and the heat dissipation can be further enhanced. On the other hand, when the volume average particle size of the plate-like graphite is the upper limit value or less, the impact resistance of the resin molded article can be further enhanced. Two or more kinds of graphite particles having different particle sizes may be used in combination as long as the volume average particle size of the plate-like graphite contained in the resin composition of the first invention is within the above range.

In the first invention, the volume average particle size refers to a value calculated in accordance with JIS Z 8825:2013 in terms of volume-based distribution by a laser diffraction method using a laser diffraction/scattering type particle size distribution measuring apparatus.

For example, plate-like graphite is put into a soap aqueous solution (neutral detergent: 0.01% contained) so as to have a concentration of 2 wt%, and is irradiated with ultrasonic waves at a power of 300 W for 1 minute using an ultrasonic homogenizer to obtain a suspension. The volume particle size distribution of the plate-like graphite is measured for the suspension by a laser diffraction/scattering type particle size distribution measuring apparatus (product name "Microtrac MT3300" manufactured by NIKKISO CO., LTD.). A cumulative value of 50% of the volume particle size distribution can be calculated as the volume average particle size of the plate-like graphite.

The content of the plate-like graphite is preferably 50 parts by weight or more, more preferably 70 parts by weight or more, and further preferably 100 parts by weight or more, and is preferably 300 parts by weight or less, more preferably 250 parts by weight or less, and further preferably 200 parts by weight or less, with respect to 100 parts by weight of the thermoplastic resin. When the content of the plate-like graphite is the lower limit value or more, the electromagnetic wave shielding properties and the heat dissipation can be further enhanced. When the content of the plate-like graphite is too large, the area of the interface serving as a starting point of the fracture increases, and thus when the content of the plate-like graphite is the upper limit value or less, the impact resistance can be further enhanced.

The aspect ratio of the plate-like graphite is preferably 5 or more and more preferably 21 or more, and is preferably less than 2000, more preferably less than 1000, and further preferably less than 100. When the aspect ratio of the plate-like graphite is the lower limit value or more, the heat dissipation in a plane direction can be further enhanced. When the aspect ratio of the plate-like graphite is less than the upper limit value, for example, the graphite particles themselves are less likely to be bent in the thermoplastic resin during injection molding. Therefore, the electromagnetic wave shielding performance can be further enhanced. In the present specification, the aspect ratio refers to a ratio of the maximum dimension of the plate-like graphite in a stacking plane direction to the thickness of the plate-like graphite.

The thickness of the plate-like graphite can be measured using, for example, a transmission electron microscope (TEM) or a scanning electron microscope (SEM). From the viewpoint of further facilitating the observation, it is desirable to perform the observation with a transmission electron microscope (TEM) or a scanning electron microscope (SEM) after heating a test piece cut out from the resin composition or the resin molded article at 600°C to evaporate the resin. The test piece may be cut out along a direction along the main surface of the resin molded article or may be cut out along a direction orthogonal to the main surface of the resin molded article as long as the thickness of the plate-like graphite can be measured by evaporating the resin.

(Carbon black (C))

First carbon black (C-1);

As the first carbon black, for example, oil furnace black such as Ketjen black, acetylene black, channel black, thermal black, and the like can be used. Among these, from the viewpoint of further enhancing the conductivity of a resulting resin molded article, oil furnace black is preferable. The ash content of the carbon black is preferably 1% or less. The carbon black may contain metal impurities such as Fe and Ni.

The BET specific surface area of the first carbon black is 600 $m^2$/g or more, preferably 700 $m^2$/g or more, and more preferably 800 $m^2$/g or more. When the BET specific surface area of the first carbon black is the lower limit value or more, the conductivity can be further enhanced. The upper limit value of the BET specific surface area of the first carbon black can be, for example, 1800 $m^2$/g and is preferably 1600 $m^2$/g or less and more preferably 1200 $m^2$/g or less.

The DBP oil absorption amount of the first carbon black is not particularly limited, and is preferably 250 ml/100 g or more, more preferably 270 ml/100 g or more, and further preferably 300 ml/100 g or more. When the DBP oil absorption amount of the first carbon black is the lower limit value or more, the conductivity can be further enhanced. The upper limit value of the DBP oil absorption amount of the first carbon black can be, for example, 600 ml/100 g.

In the present specification, the DBP oil absorption amount of the carbon black can be obtained by calculating a DBP dropping amount at 70% of the maximum torque in accordance with JIS K 6217-4. The DBP oil absorption amount can be measured using, for example, an absorption amount measuring instrument (Product No. "S-500" manufactured by Asahi Souken Co., Ltd.).

The primary particle size of the first carbon black is not particularly limited, and is preferably 15 nm or more and more preferably 20 nm or more, and is preferably 60 nm or less and more preferably 50 nm or less. When the primary particle size of the first carbon black is within the above range, higher conductivity can be obtained at a lower concentration of the first carbon black content.

In the present specification, the primary particle size of the carbon black is, for example, an average primary particle size obtained using image data of the carbon black obtained by a transmission electron microscope. As the transmission electron microscope, for example, product name "JEM-2200FS" manufactured by JEOL Ltd. can be used.

The content of the first carbon black is preferably 5 parts by weight or more and more preferably 10 parts by weight or more, and is preferably 50 parts by weight or less and more preferably 40 parts by weight or less, with respect to 100 parts by weight of the thermoplastic resin. When the content of the first carbon black is the lower limit value or more, the conductivity can be further enhanced. When the content of the first carbon black is the upper limit value or less, the fluidity during molding can be further improved, and the moldability can be further improved.

Second carbon black (C-2);

As the second carbon black, for example, oil furnace black such as Ketjen black, acetylene black, channel black, thermal black, and the like can be used. Among these, from the viewpoint of further enhancing the conductivity of a resulting resin molded article, oil furnace black is preferable. In particular, both of the first carbon black and the second carbon black are more preferably oil furnace black. The ash content of the carbon black is preferably 1% or less. The carbon black may contain metal impurities such as Fe and Ni.

The BET specific surface area of the second carbon black is less than 600 $m^2$/g, preferably 400 $m^2$/g or less, and more preferably 300 $m^2$/g or less. When the BET specific surface area of the second carbon black is less than the upper limit value or the upper limit value or less, the fluidity during molding can be further improved, and the moldability can be further improved. The lower limit value of the BET specific surface area of the second carbon black can be, for example, 30 $m^2$/g and is preferably 100 $m^2$/g or more and more preferably 150 $m^2$/g or more.

The DBP oil absorption amount of the second carbon black is not particularly limited, and is preferably less than 250 ml/100 g and more preferably 200 ml/100 g or less. When the DBP oil absorption amount of the second carbon black is less than the upper limit value or the upper limit value or less, the fluidity during molding can be further improved, and the moldability can be further improved. The lower limit value of the DBP oil absorption amount of the second carbon black can be, for example, 30 ml/100 g.

The primary particle size of the second carbon black is preferably 5 nm or more, more preferably 10 nm or more, and further preferably 15 nm or more, and is preferably 80 nm or less, more preferably 70 nm or less, further preferably 60 nm or less, and particularly preferably 50 nm or less. When the primary particle size of the second carbon black is within the above range, higher conductivity can be obtained at a lower concentration of the second carbon black content.

The content of the second carbon black is preferably 5 parts by weight or more and more preferably 10 parts by weight or more, and is preferably 50 parts by weight or less and more preferably 40 parts by weight or less, with respect to 100 parts by weight of the thermoplastic resin. When the content of the second carbon black is the lower limit value or more, the fluidity during molding can be further improved, and the moldability can be further improved. When the content of the second carbon black is the upper limit value or less, the conductivity can be further enhanced.

A ratio (C-1)/(C-2) of the first carbon black to the second carbon black is, in terms of weight ratio, preferably 0.01 or more, more preferably 0.1 or more, and further preferably 0.5 or more, and is preferably 10 or less, more preferably 5 or less, and further preferably 2 or less. When (C-1)/(C-2) is the lower limit value or more, the conductivity can be further enhanced. When (C-1)/(C-2) is the upper limit value or less, the fluidity during molding can be further improved, and the moldability can be further improved.

The content of the entire carbon black is preferably 15 parts by weight or more and more preferably 25 parts by weight or more, and is preferably 90 parts by weight or less and more preferably 70 parts by weight or less, with respect to 100 parts by weight of the thermoplastic resin. When the content of the entire carbon black is the lower limit value or more, the conductivity can be further enhanced. When the content of the entire carbon black is the upper limit value or less, the fluidity during molding can be further improved, and the moldability can be further improved.

The carbon black may further include carbon black other than the first carbon black and the second carbon black. As the other carbon black, the carbon black described in the section of the first carbon black and the second carbon black can be appropriately used.

(Other additives)

Various other additives may be added as optional components to the resin composition of the first invention as long as the effects of the first invention are not impaired. Examples of the additives include antioxidants such as phenol-based, phosphorus-based, amine-based, and sulfur-based antioxidants; ultraviolet absorbers such as benzotriazole-based and hydroxyphenyltriazine-based ultraviolet absorbers; a metal inhibitor; various fillers; an antistatic agent; a stabilizer; and a pigment. These may be used alone or in combination of two or more thereof.

(Method for producing resin composition)

The above-described resin composition can be obtained by first melt-kneading a thermoplastic resin (A), graphite (B), a first carbon black (C-1) having a BET specific surface area of 600 $m^2/g$ or more, a second carbon black (C-2) having a BET specific surface area of less than 600 $m^2/g$, and other additives as necessary.

The melt-kneading method is not particularly limited, and examples thereof include a method in which kneading is performed under heating using a kneading apparatus such as twin-screw kneader such as a plastomill, a single-screw extruder, a twin-screw extruder, a Banbury mixer, a roll, or a pressurizing kneader. Among them, a method of melt-kneading using an extruder is preferable. The form of the resin composition of the first invention is not particularly limited, and can be, for example, a pellet.

In the case of a pellet, the shape thereof is not particularly limited, and examples thereof include a spherical shape, a cylindrical shape, and a prismatic shape. Among them, from the viewpoint of the stability of the pellet shape, a cylindrical shape is preferable. Regarding the size of the pellet, when the shape of the pellet is, for example, cylindrical, the diameter thereof is preferably 0.5 mm or more and more preferably 1 mm or more, and is preferably 5 mm or less and more preferably 3 mm or less. The length thereof is preferably 1 mm or more and more preferably 3 mm or more, and is preferably 10 mm or less and more preferably 7 mm or less. The size of the pellet can be measured by randomly collecting 100 pellets from a sample and using a caliper.

The diameter of the pellet (pellet diameter) of the resin composition other than the cylindrical shape is preferably 1 mm or more and more preferably 5 mm or more, and is preferably 15 mm or less and more preferably 10 mm or less. The pellet diameter can be determined by randomly collecting 100 pellets from a sample and measuring the diameter at the longest point using a caliper.

In the resin composition of the first invention, a specific volume resistivity is preferably $1.0 \times 10^5$ $\Omega \cdot cm$ or less and more preferably $1.0 \times 10^2$ $\Omega \cdot cm$ or less. The lower limit value of the specific volume resistivity is not particularly limited, and is, for example, $1.0 \times 10^{-4}$ $\Omega \cdot cm$. The specific volume resistivity can be calculated from a resistivity correction coefficient and the thickness of the resin composition by measuring a resistance value using a low-resistance resistivity meter. For example, the specific volume resistivity can be measured at room temperature in the atmosphere by a four probe method resistivity measurement device (Loresta AX MCP-T370, manufactured by Mitsubishi Chemical Analytech Co., Ltd.).

[Second invention]

A resin composition of the second invention of the present application contains a thermoplastic resin (A), graphite (B), and carbon black (D). In the resin composition of the second invention, the relaxation time of the L component is 1.3 msec or less when the following measurement is performed using pulsed NMR.

The above-described measurement by pulsed NMR can be performed, for example, as follows. Into a glass sample tube (Product No. 1824511 manufactured by BRUKER, diameter: 10 mm, length: 180 mm, flat bottom) having a diameter of 10 mm, 700 mg of a sample of a resin molded article obtained under the following molding conditions is introduced. The sample tube is then placed in a pulsed NMR apparatus ("the minispe mq20" manufactured by BRUKER) and held at 125°C for 10 minutes. Thereafter, the Hahn Echo method is performed at 125°C, and the free induction decay curve of the spin-spin relaxation of ¹H thus obtained is subjected to waveform separation into three curves respectively derived from three components of an S component, an M component, and an L component in ascending order of relaxation time by a least-squares method.

<Molding conditions>

The resin composition of the second invention in a molten state is filled in a mold from a direction orthogonal to a thickness direction of a resulting resin molded article and molded to obtain a resin molded article of 100 mm in length × 100 mm in width × 2 mm in thickness. A flat plate of the obtained resin molded article is cut into 5 mm square to obtain a sample of the resin molded article.

Waveform separation is performed by fitting using an exponential type. The fitting is performed according to the product manual using analysis software "TD-NMRA (Version 4.3 Rev 0.8)" manufactured by BRUKER.

The following formula is used for fitting.

$$Y = A1 \times \exp(-1 \div w1 \times (t \div T2A)^{w1}) + B1 \times \exp(-1 \div w2 \times (t \div T2B)^{w2}) + C1 \times \exp(-1 \div w3 \times (t \div T2C)^{w3})$$

where w1 to w3 are Weibull coefficients, and w1, w2, and w3 take values of 1. A1 represents a component ratio of the S component, B1 represents a component ratio of the M component, C1 represents a component ratio of the L component, T2A represents a relaxation time of the S component, T2B represents a relaxation time of the M component, and T2C represents a relaxation time of the L component, t is time.

In the Hahn Echo method, the following setting is performed.

Scans: 16times
Recycle Deray: 1sec
First 90-180 Pluse Separation: 0.0082msec
Final Pluse Separation: 5msec
Number of Points for Fitting: 100

The above-described measurement conditions are an example, and it is desirable to set the Final Pluse Separation so that the intensity of the normalized relaxation curve is 0.02 msec or less, and it is desirable to set the Recycle Deray so as to be 5 times the longitudinal relaxation time T1.

In general, a free induction decay curve of the spin-spin relaxation of ¹H is obtained as measured by pulsed NMR. The obtained free induction decay curve can be subjected to waveform separation into three curves derived from three components of an S component, an M component, and an L component in ascending order of relaxation time. That is, the measured free induction decay curve is obtained by superimposing free induction decay curves derived from three components of the S component, the M component, and the L component. Such a method of separation into three components using pulsed NMR and analyzing the components is known, and examples of documents describing the method include JP 2018-2983 A.

The S component is a component having a short relaxation time in pulsed NMR measurement, and means a hard component having low molecular mobility. On the other hand, the L component is a component having a long relaxation time in pulsed NMR measurement, and means a soft component having high molecular mobility. The M component has a relaxation time in pulsed NMR measurement between the S component and the L component, so that the molecular mobility is also between the S component and the L component.

In the resin composition of the second invention, when the relaxation time of the L component is 1.3 msec or less, the long-term heat resistance can be improved. The relaxation time of the L component is preferably 1.2 msec or less and more preferably 1.0 msec or less. The lower limit value of the relaxation time of the L component is not particularly limited, and can be, for example, 0.5 msec.

In the resin composition of the second invention, a ratio (L component/ (S component + M component + L component)) of the L component to the sum of the S component, the M component, and the L component is preferably 4% or more and more preferably 50 or more, and is preferably 10% or less and more preferably 9% or less. When the ratio (L component/(S component + M component + L component)) is within the above range, the long-term heat resistance can be further improved.

The relaxation time and the component ratio of the L component in the resin composition of the second invention can be set to the above ranges by adjusting the type and content ratio of each component constituting the resin composition. The L component, which is a soft component having high molecular mobility, can be controlled by affinity between the resin composition and a filler and dispersibility between fillers that inhibit molecular mobility. Therefore, the relaxation time of the L component can be further shortened by including two or more kinds of carbon black (D) in the resin composition or by producing the resin composition by a production method using dry blending to be described later.

Hereinafter, each component of the resin composition will be described in detail.

(Thermoplastic resin (A))

The thermoplastic resin is not particularly limited, and a known thermoplastic resin can be used. Specific examples of the thermoplastic resin include polyolefins, polystyrenes, polyacrylates, polymethacrylates, polyacrylonitriles, polyesters, polyamides, polyurethanes, polyethersulfones, polyetherketones, polyimides, polydimethylsiloxanes, polycarbonates, and copolymers containing at least two of these. These thermoplastic resins may be used alone or in combination of two or more thereof. The thermoplastic resin is preferably a resin having a high elastic modulus. Polyolefins (olefin-based resin) and polyamides (nylon-based resin) are more preferable and polyolefin is further preferable, because they are inexpensive and easy to mold under heating.

The polyolefins are not particularly limited, and a known polyolefin can be used. Specific examples of the polyolefins include a polyethylene which is an ethylene homopolymer, and polyethylene-based resins such as an ethylene-$\alpha$-olefin copolymer, an ethylene-(meth)acrylic acid copolymer, an ethylene-(meth)acrylic acid ester copolymer, and an ethylene-vinyl acetate copolymer. The polyolefin may be polypropylene which is a propylene homopolymer, a polypropylene-based resin such as a propylene-$\alpha$-olefin copolymer, polybutene which is a butene homopolymer, or a homopolymer or copolymer of a conjugated diene such as butadiene or isoprene. These polyolefins may be used alone or in combination of two or more thereof. From the viewpoint of further enhancing heat resistance and elastic modulus, the polyolefin is preferably polypropylene.

The polyolefin (olefin-based resin) preferably contains an ethylene component. The content of the ethylene component is preferably 5 mass% to 40 mass%. When the content of the ethylene component is within the above range, the heat resistance can be further enhanced while the impact resistance of the resin molded article is further enhanced.

The MFR of the thermoplastic resin measured in accordance with JIS K7210 is preferably 10 g/10 min or more and more preferably 30 g/10 min or more, and is preferably 200 g/10 min or less and more preferably 150 g/10 min or less. When the MFR is within the above range, the fluidity of the thermoplastic resin can be further enhanced.

The content of the thermoplastic resin in the resin composition is preferably 20 wt% or more and more preferably 25 wt% or more, and is preferably 65 wt% or less and more preferably 60 wt% or less. When the content of the thermoplastic resin is within the above range, the moldability of the resin composition can be further enhanced.

(Graphite (B))

The graphite is not particularly limited, and is preferably plate-like graphite. The plate-like graphite is not particularly limited as long as it is plate-like graphite, and for example, graphite, flaked graphite, graphene, or the like can be used. From the viewpoint of further enhancing thermal conductivity and flame retardancy, graphite or flaked graphite is preferable. These may be used alone or in combination of two or more thereof. In the second invention, as the plate-like graphite, for example, scale-like graphite can be used. From the viewpoint of further enhancing the flame retardancy, expanded graphite may be used.

The flaked graphite is obtained by peeling treatment of the original graphite, and refers to a graphene sheet laminate thinner than the original graphite. The peeling treatment for forming flaked graphite is not particularly limited, and either a mechanical peeling method using a supercritical fluid or the like or a chemical peeling method using an acid may be used. The number of laminated graphene sheets in the flaked graphite may be any number as long as it is smaller than that of the original graphite, and is preferably 1000 layers or less, more preferably 500 layers or less, and further preferably 200 layers or less.

In the second invention, the volume average particle size of the plate-like graphite is preferably 5 pm or more, more preferably 30 um or more, and further preferably 60 um or more, and is preferably 500 um or less, more preferably 350 um or less, and further preferably 300 um or less. When the volume average particle size of the plate-like graphite is the lower limit value or more, the electromagnetic wave shielding properties and the heat dissipation can be further enhanced. On the other hand, when the volume average particle size of the plate-like graphite is the upper limit value or less, the impact resistance of the resin molded article can be further enhanced. Two or more kinds of graphite particles having different particle sizes may be used in combination as long as the volume average particle size of the plate-like graphite contained in the resin composition of the second invention is within the above range.

In the second invention, the volume average particle size refers to a value calculated in accordance with JIS Z 8825:2013 in terms of volume-based distribution by a laser diffraction method using a laser diffraction/scattering type particle size distribution measuring apparatus.

For example, plate-like graphite is put into a soap aqueous solution (neutral detergent: 0.01% contained) so as to have a concentration of 2 wt%, and is irradiated with ultrasonic waves at a power of 300 W for 1 minute using an ultrasonic homogenizer to obtain a suspension. The volume particle size distribution of the plate-like graphite is measured for the suspension by a laser diffraction/scattering type particle size distribution measuring apparatus (product name "Microtrac MT3300" manufactured by NIKKISO CO., LTD.). A cumulative value of 50% of the volume particle size distribution can be calculated as the volume average particle size of the plate-like graphite.

The content of the plate-like graphite is preferably 50 parts by weight or more, more preferably 70 parts by weight or more, and further preferably 100 parts by weight or more, and is preferably 300 parts by weight or less, more preferably 250 parts by weight or less, and further preferably 200 parts by weight or less, with respect to 100 parts by weight of the thermoplastic resin. When the content of the plate-like graphite is the lower limit value or more, the electromagnetic wave shielding properties and the heat dissipation can be further enhanced. When the content of the plate-like graphite is too large, the area of the interface serving as a starting point of the fracture increases, and thus when the content of the plate-like graphite is the upper limit value or less, the impact resistance can be further enhanced.

The aspect ratio of the plate-like graphite is preferably 5 or more and more preferably 21 or more, and is preferably less than 2000, more preferably less than 1000, and further preferably less than 100. When the aspect ratio of the plate-like graphite is the lower limit value or more, the heat dissipation in a plane direction can be further enhanced. When the aspect ratio of the plate-like graphite is less than the upper limit value, for example, the graphite particles themselves are less likely to be bent in the thermoplastic resin during injection molding. Therefore, the electromagnetic wave shielding performance can be further enhanced. In the present specification, the aspect ratio refers to a ratio of the maximum dimension of the plate-like graphite in a stacking plane direction to the thickness of the plate-like graphite.

The thickness of the plate-like graphite can be measured using, for example, a transmission electron microscope (TEM) or a scanning electron microscope (SEM). From the viewpoint of further facilitating the observation, it is desirable to perform the observation with a transmission electron microscope (TEM) or a scanning electron microscope (SEM) after heating a test piece cut out from the resin composition or the resin molded article at 600°C to evaporate the resin. The test piece may be cut out along a direction along the main surface of the resin molded article or may be cut out along a direction orthogonal to the main surface of the resin molded article as long as the thickness of the plate-like graphite can be measured by evaporating the resin.

(Carbon black (D))

As the carbon black, for example, oil furnace black such as Ketjen black, acetylene black, channel black, thermal black, and the like can be used. Among these, from the viewpoint of further enhancing the conductivity of a resulting resin molded article, oil furnace black is preferable. The ash content of the carbon black is preferably 1% or less. The carbon black may contain metal impurities such as Fe and Ni.

The BET specific surface area of the carbon black is preferably 30 $m^2$/g or more and more preferably 50 $m^2$/g or more, and is preferably 2,000 $m^2$/g or less and more preferably 1,500 $m^2$/g or less. When the BET specific surface area of the carbon black is within the above range, the conductivity can be further improved.

The BET specific surface area can be measured from an adsorption isotherm of nitrogen in accordance with a BET method. As a measuring device, for example, Product No. "NOVA touch LX2" manufactured by Anton Paar GmbH can be used.

The DBP oil absorption amount of the carbon black is not particularly limited, and is preferably 50 ml/100 g or more and more preferably 100 ml/100 g or more, and is preferably 450 ml/100 g or less and more preferably 400 ml/100 g or less. When the DBP oil absorption amount of the carbon black is within the above range, the conductivity can be further improved.

In the present specification, the DBP oil absorption amount of the carbon black can be obtained by calculating a DBP dropping amount at 70% of the maximum torque in accordance with JIS K 6217-4. The DBP oil absorption amount can be measured using, for example, an absorption amount measuring instrument (Product No. "S-500" manufactured by Asahi Souken Co., Ltd.).

The primary particle size of the carbon black is not particularly limited, and is preferably 30 nm or more and more preferably 35 nm or more, and is preferably 50 nm or less and more preferably 45 nm or less. When the primary particle size of the carbon black is within the above range, higher conductivity can be obtained at a lower concentration of the carbon black content.

In the present specification, the primary particle size of the carbon black is, for example, an average primary particle size obtained using image data of the carbon black obtained by a transmission electron microscope. As the transmission electron microscope, for example, product name "JEM-2200FS" manufactured by JEOL Ltd. can be used.

The content of the carbon black is preferably 3 parts by weight or more and more preferably 5 parts by weight or more, and is preferably 200 parts by weight or less and more preferably 150 parts by weight or less, with respect to 100 parts by weight of the thermoplastic resin. When the content of the carbon black is within the above range, the conductivity and the long-term heat resistance can be further enhanced.

As the carbon black, two or more kinds of carbon black may be used. For example, as the carbon black, the first carbon black (C-1) and the second carbon black (C-2) of the first invention may be used. Preferred ranges of the content and the content ratio are the same as those of the resin composition of the first invention. In this case, the relaxation time of the L component in pulsed NMR measurement can be further shortened.

(Other additives)

Various other additives may be added as optional components to the resin composition of the second invention as long as the effects of the second invention are not impaired. Examples of the additives include antioxidants such as phenol-based, phosphorus-based, amine-based, and sulfur-based antioxidants; ultraviolet absorbers such as benzotriazole-based and hydroxyphenyltriazine-based ultraviolet absorbers; a metal inhibitor; various fillers; an antistatic agent; a stabilizer; and a pigment. These may be used alone or in combination of two or more thereof.

(Method for producing resin composition)

The above-described resin composition can be obtained by first melt-kneading a thermoplastic resin (A), graphite (B), carbon black (D), and other additives as necessary.
The melt-kneading method is not particularly limited, and examples thereof include a method in which kneading is performed under heating using a kneading apparatus such as twin-screw kneader such as a plastomill, a single-screw extruder, a twin-screw extruder, a Banbury mixer, a roll, or a pressurizing kneader. Among them, a method of melt-kneading using an extruder is preferable. The form of the resin composition of the second invention is not particularly limited, and can be, for example, a pellet.
In the resin composition of the second invention, a specific volume resistivity is preferably $1.0 \times 10^5$ $\Omega \cdot$cm or less and more preferably $1.0 \times 10^2$ $\Omega \cdot$cm or less. The lower limit value of the specific volume resistivity is not particularly limited, and is, for example, $1.0 \times 10^{-4}$ $\Omega \cdot$cm. The specific volume resistivity can be calculated from a resistivity correction coefficient and the thickness of the resin composition by measuring a resistance value using a low-resistance resistivity meter. For example, the specific volume resistivity can be measured at room temperature in the atmosphere by a four probe method resistivity measurement device (Loresta AX MCP-T370, manufactured by Mitsubishi Chemical Analytech Co., Ltd.).
Hereinafter, the first invention and the second invention may be collectively referred to as the present invention. Each of the first invention and the second invention may be implemented alone, or may be implemented by combining the first invention and the second invention.
In the resin composition of the present invention, when a resin molded article is obtained under the following conditions, the electromagnetic wave shielding effect of the resin molded article at a frequency of any of 3 GHz, 25 GHz, 50 GHz, and 75 GHz is preferably 20 dB or more, more preferably 20 dB or more, and further preferably 41 dB or more. The upper limit value of the electromagnetic wave shielding effect of the resin molded article is not particularly limited, and can be, for example, 80 dB.

<Molding conditions>

The resin composition in a molten state is filled in a mold from a direction orthogonal to a thickness direction of a resulting resin molded article and molded to obtain a resin molded article of 100 mm in length $\times$ 100 mm in width $\times$ 2 mm in thickness.
In the resin composition of the present invention, when a resin molded article is obtained under the following conditions, a thermal conductivity in an in-plane direction of the resin molded article is preferably 1 W/(m·K) or more, more preferably 3 W/(m·K) or more, and further preferably 5 W/(m·K) or more. The upper limit value of the thermal conductivity in the in-plane direction of the resin molded article can be, for example, 50 W/(m·K).

<Molding conditions>

The resin composition in a molten state is filled in a mold from a direction orthogonal to a thickness direction of a resulting resin molded article and molded to obtain a resin molded article of 100 mm in length $\times$ 100 mm in width $\times$ 2 mm in thickness.

[Method for producing resin molded article]

A resin molded article according to the present invention is a molded article of the above-described resin composition according to the present invention. Therefore, the resin molded article of the present invention can be obtained by molding the above-described resin composition.

The molding method is not particularly limited, and examples thereof include methods such as press working, extrusion processing, extrusion lamination processing, and injection molding. Among them, it is preferable to mold the mixture by injection molding. In this case, the mechanical strength of the resulting resin molded article can be further enhanced.

In the present invention, a resin molded article may be obtained by mixing the above-described resin composition according to the present invention and a composite body (E) containing a thermoplastic resin and a fiber to obtain a mixture and molding the mixture.

In the second invention, the mixture of the above-described resin composition and the composite body (E) is desirably used as the resin composition of the second invention. Therefore, also in the measurement in pulsed NMR, it is desirable to subject the mixture of the above-described resin composition and the composite body to the measurement. By forming such a mixture, the relaxation time of the L component in pulsed NMR measurement can be further shortened.

When a mixture is obtained, it is preferable to mix the resin composition and the composite body (E) by dry blending. In this case, a resin molded article further excellent in mechanical strength can be obtained.

In the present specification, dry blending means mixing without melting or addition of a solvent. Such a dry blending method is not particularly limited, and can be performed, for example, by simply mixing the resin composition and the composite body (E) with a hand. Mixing may be performed using a small tumbler or the like.

As the thermoplastic resin contained in the composite body (E), the thermoplastic resin described in the section of the resin composition described above can be used. The thermoplastic resin contained in the composite body (E) is desirably the same resin as the thermoplastic resin contained in the resin composition, but may be a different resin.

The fiber may be an inorganic fiber or an organic fiber. An inorganic fiber and an organic fiber may be used in combination.

As the fiber, for example, metal fibers, carbon fibers, cellulose fibers, aramid fibers, glass fibers, or the like can be used. These may be used alone or in combination of two or more thereof.

The carbon fibers are not particularly limited, and PAN-based or pitch-based carbon fibers and the like can be used.

The fibers are preferably oriented in the thermoplastic resin. Among them, uniaxial orientation is preferable. Such a composite body (E) can be produced by aligning fibers and bringing the fibers into contact with a molten thermoplastic resin. In particular, in the case of production by a pultrusion method, a composite body (E) in which the fiber is impregnated with the thermoplastic resin can be obtained. The form of the composite body (E) is not particularly limited, and can be, for example, a pellet.

The fiber length is not particularly limited, and is preferably 3 mm or more and more preferably 5 mm or more, and is preferably 20 mm or less and more preferably 15 mm or less. When the fiber length is within the above range, the mechanical strength of the resulting resin molded article can be further enhanced.

The fiber diameter of the fiber is preferably 5 um or more and more preferably 10 um or more, and is preferably 50 um or less and more preferably 30 um or less. When the fiber diameter of the fiber is within the above range, the mechanical strength of the resulting resin molded article can be further enhanced.

The fiber length and the fiber diameter can be, for example, average values of 100 fibers measured using a transmission electron microscope (TEM) or a scanning electron microscope (SEM). From the viewpoint of further facilitating the observation, it is desirable to perform the observation with a transmission electron microscope (TEM) or a scanning electron microscope (SEM) after heating a test piece cut out from the composite body (E) or the resin molded article at 600°C to evaporate the resin.

The content of the fiber is not particularly limited, and is preferably 50 parts by weight or more and 200 parts by weight or less with respect to 100 parts by weight of the thermoplastic resin contained in the composite body (E). When the content of the fiber is within the above range, the mechanical strength of the resulting resin molded article can be further enhanced.

[Resin molded article]

A resin molded article of the present invention can be obtained by the method for producing a resin molded article described above. In the method for producing a resin molded article described above, since the resin composition of the present invention is used, the resin molded article is excellent in conductivity, and thus excellent in electromagnetic wave shielding properties.

In the resin molded article of the present invention, a specific volume resistivity is preferably $1.0 \times 10^5$ $\Omega \cdot$cm or less and more preferably $1.0 \times 10^3$ $\Omega \cdot$cm or less. In this case, the electromagnetic wave shielding properties of the resin molded article can be further enhanced. The lower limit value of the specific volume resistivity is not particularly limited, and can be, for example, $1.0 \times 10^{-4}$ $\Omega \cdot$cm.

The specific volume resistivity can be calculated from a resistivity correction coefficient and the thickness of the resin molded article by measuring a resistance value using a low-resistance resistivity meter. For example, the specific volume resistivity can be measured at room temperature in the atmosphere by a four probe method resistivity measurement device (Loresta AX MCP-T370, manufactured by Mitsubishi Chemical Analytech Co., Ltd.).

In the resin molded article of the present invention, the electromagnetic wave shielding effect at a frequency of 3 GHz is preferably 20 dB or more, more preferably 25 dB or more, and further preferably 30 dB or more. The upper limit value of the electromagnetic wave shielding effect is not particularly limited, and is, for example, 80 dB.

The electromagnetic wave shielding effect (electromagnetic wave shielding performance) at a frequency of 3 GHz can be measured using, for example, a dual-focus flat cavity (DFFC) method.

In the present invention, the thermal conductivity in the in-plane direction of the main surface of the resin molded article is preferably 2 W/(m·K) or more, more preferably 5 W/(m·K) or more, and further preferably 10 W/(m·K) or more. In this case, the heat dissipation of the resin molded article can be further enhanced. The upper limit value of the thermal conductivity in the in-plane direction is not particularly limited, and can be, for example, 50 W/(m·K).

The main surface may be a flat surface or a curved surface. In the present invention, the main surface is a surface having the largest area among a plurality of surfaces on the outer surface of the resin molded article, and refers to a continuous surface.

The thermal conductivity in the in-plane direction can be calculated using the following Formula (1).

$$\text{Thermal conductivity } (W/(m \cdot K)) = \text{Specific gravity } (g/cm^3) \times \text{Specific heat } (J/g \cdot K) \times \text{Thermal diffusivity } (mm^2/s) \quad \ldots \quad \text{Formula (1)}$$

The thermal diffusivity can be measured using, for example, Product No. "Xenon Flash Laser Analyzer LFA 467 HyperFlash" manufactured by NETZSCH Japan K.K.

Since the resin molded article of the present invention is excellent in electromagnetic wave shielding properties, the resin molded article can be suitably used for a casing of a communication device or an electronic device, such as a smart meter or an in-vehicle ECU, which requires electromagnetic wave shielding properties.

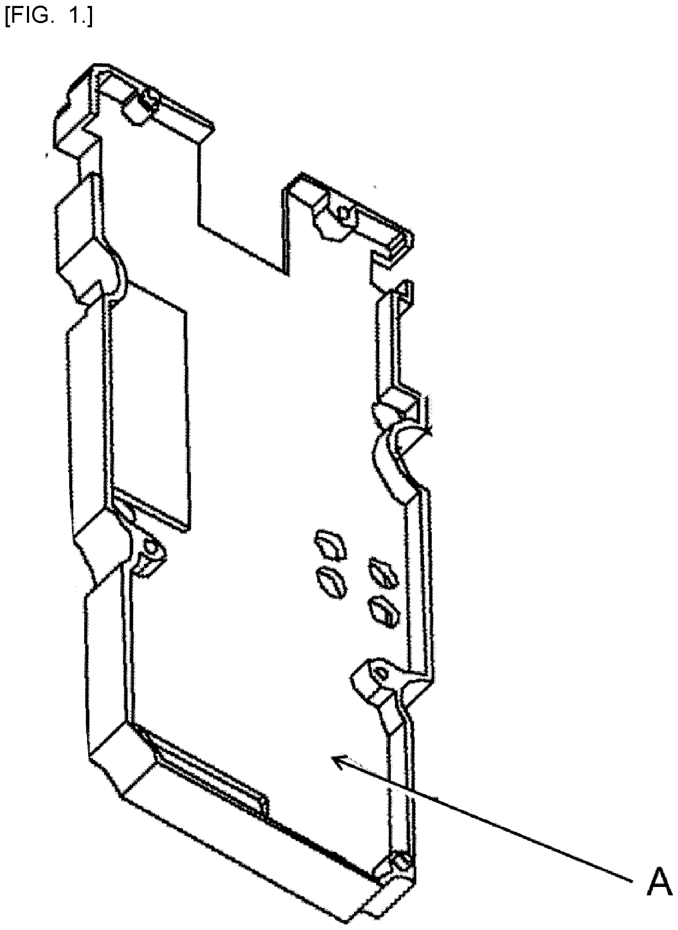

The resin molded article of the present invention may be a heat dissipation chassis, a heat dissipation casing, or a heat sink shape. Hereinafter, specific examples of a heat dissipation chassis, a heat dissipation casing, and a heat sink shape will be described with reference to Figs. 1 to 3.

Fig. 1 is a schematic perspective view of a heat dissipation chassis. When the resin molded article is a heat dissipation chassis, a portion indicated by arrow A in Fig. 1 is a main surface.

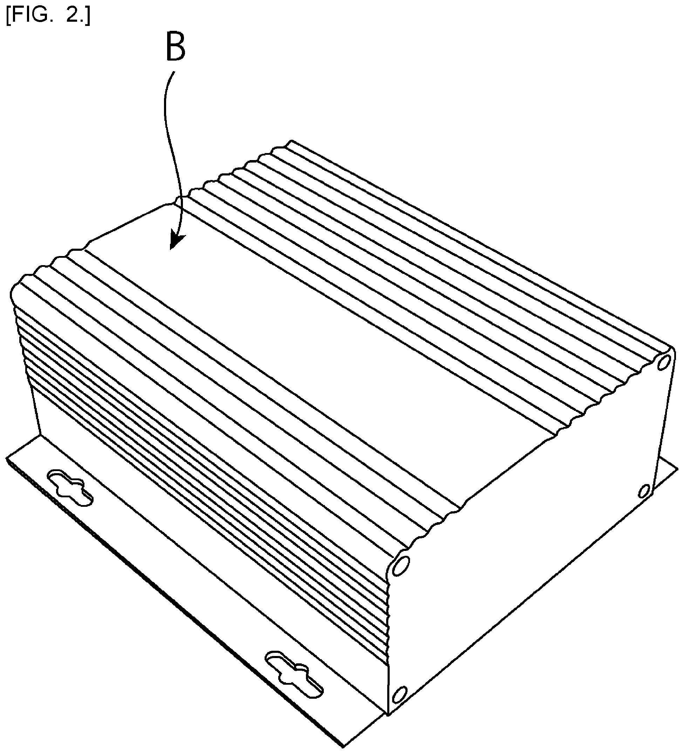

Fig. 2 is a schematic perspective view of a heat dissipation casing. When the resin molded article is a heat dissipation casing, a portion indicated by arrow B in Fig. 2 is a main surface. As illustrated in Figs. 1 and 2, the main surface may have irregularities.

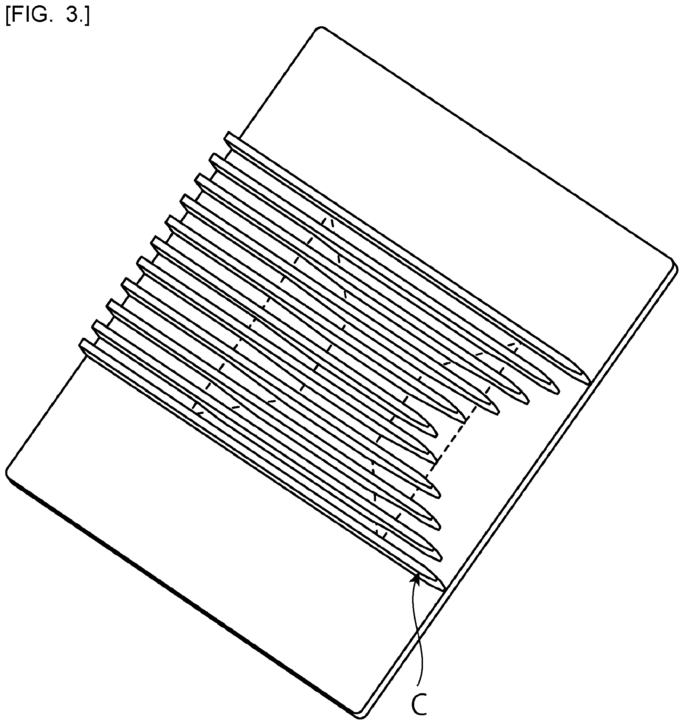

Fig. 3 is a schematic perspective view of a heat sink shape. When the resin molded article is a heat sink shape, a portion indicated by arrow C in Fig. 3 is a main surface. Specifically, the main surface on one side of a bottom plate portion and the surface of a fin portion are the main surfaces. In this manner, a plurality of main surfaces may be present.

A circuit may be formed on the surface of such a resin molded article.

Hereinafter, the effects of the present invention will be clarified with reference to specific Examples and Comparative Examples of the present invention. The present invention is not limited to the following Examples.

(Example 1)

Polypropylene (PP) (100 parts by weight) as the thermoplastic resin, scale-like graphite particles (150 parts by weight) as the plate-like graphite particles, oil furnace black (20 parts by weight) as the first carbon black, and oil furnace black (20 parts by weight) as the second carbon black were melt-kneaded at 200°C using Labo Plastomill (Product No. "R100" manufactured by Toyo Seiki Seisaku-sho, Ltd.) to obtain a resin composition. The obtained resin composition was injection-molded at a resin composition temperature of 230°C and a mold temperature of 40°C to obtain a resin molded article of 300 mm in length × 300 mm in width × 2 mm in thickness. As the polypropylene, trade name "BC08F" (MFR: 70 g/10 min (230°C)) manufactured by Japan Polypropylene Corporation was used. As the scale-like graphite particles, trade name "CPB-100B" (volume average particle size: 80 μm) manufactured by Chuetsu Graphite Works Co., Ltd. was used. As the oil furnace black of the first carbon black, trade name "EC300J" (BET specific surface area: 800 m²/g, DBP oil absorption amount: 365 ml/100 g, primary particle size: 40 nm) manufactured by Lion Corporation was used. As the oil furnace black of the second carbon black, trade name "VulcanXC72" (BET specific surface area: 254 m²/g, DBP oil absorption amount: 174 ml/100 g, primary particle size: 30 nm) manufactured by Cabot Corporation was used.

The MFR of the thermoplastic resin in Examples and Comparative Examples was measured in accordance with JIS K7210. The volume average particle size of the graphite was calculated in accordance with JIS Z 8825:2013 in terms of volume-based distribution by a laser diffraction method using a laser diffraction/scattering type particle size distribution measuring apparatus (product name "Microtrac MT3300" manufactured by NIKKISO CO., LTD.). The BET specific surface areas of the first and second carbon blacks were measured from an adsorption isotherm of nitrogen in accordance with a BET method. As a measuring device, Product No. "NOVA touch LX2" manufactured by Anton Paar GmbH was used. The DBP oil absorption amounts of the first and second carbon blacks were measured using an absorption amount measuring instrument (Product No. "S-500" manufactured by Asahi Souken Co., Ltd.) and were obtained by calculating a DBP dropping amount at 70% of the maximum torque in accordance with JIS K 6217-4. The primary particle sizes of the first and second carbon blacks were determined from the average value of 1,000 carbon blacks in image data obtained by a transmission electron microscope (product name "JEM-2200FS" manufactured by JEOL Ltd.).

(Example 2)

A resin composition and a resin molded article were obtained in the same manner as in Example 1, except that the oil furnace black as the first carbon black was changed to trade name "LIGNITE CB" (BET specific surface area: 1,052 $m^2$/g, DBP oil absorption amount: 280 ml/100 g, primary particle size: 41 nm) manufactured by Lion Corporation.

(Example 3)

A resin composition and a resin molded article were obtained in the same manner as in Example 1, except that the oil furnace black as the first carbon black was changed to trade name "Black Pearls 2000" (BET specific surface area: 1,475 $m^2$/g, DBP oil absorption amount: 330 ml/100 g, primary particle size: 15 nm) manufactured by Cabot Corporation.

(Example 4)

A resin composition and a resin molded article were obtained in the same manner as in Example 1, except that the oil furnace black as the second carbon black was changed to trade name "F-200GS" (BET specific surface area: 55 $m^2$/g, DBP oil absorption amount: 55 ml/100 g, primary particle size: 38 nm) manufactured by Asahi Carbon Co., Ltd.

(Example 5)

A resin composition and a resin molded article were obtained in the same manner as in Example 1, except that the scale-like graphite particles as the plate-like graphite particles were changed to trade name "CPB-300" (volume average particle size: 300 $\mu$m) manufactured by Chuetsu Graphite Works Co., Ltd.

(Example 6)

A resin composition and a resin molded article were obtained in the same manner as in Example 1, except that the scale-like graphite particles as the plate-like graphite particles were changed to trade name "F#2" (volume average particle size: 140 $\mu$m) manufactured by Nippon Graphite Industries, Co., Ltd.

(Example 7)

A resin composition and a resin molded article were obtained in the same manner as in Example 1, except that polypropylene (PP) as the thermoplastic resin was changed to trade name "SA06GA" (MFR: 60 g/10 min (230°C)) manufactured by Japan Polypropylene Corporation.

(Example 8)

A resin composition and a resin molded article were obtained in the same manner as in Example 1, except that the thermoplastic resin was changed to 6-nylon, trade name "CM1007" (MFR: 62 g/10 min (260°C)) manufactured by Toray Industries, Inc., and the melt-kneading temperature and the injection molding temperature were changed to 230°C and 260°C, respectively.

(Example 9)

Production of resin composition (A-1);

Polypropylene (PP) (100 parts by weight) as the thermoplastic resin, scale-like graphite (160 parts by weight) as the plate-like graphite, oil furnace black (20 parts by weight) as the first carbon black, and oil furnace black (20 parts by weight) as the second carbon black were used. These were melt-kneaded at 200°C using Labo Plastomill (Product No. "R100" manufactured by Toyo Seiki Seisaku-sho, Ltd.) to obtain a resin composition (A-1).

The obtained resin composition (A-1) had a pellet shape and a pellet diameter of 3 mm. The pellet diameter was determined by randomly collecting 100 pellets from a sample and measuring the diameter at the longest point using a caliper. As the polypropylene, trade name "MA04A" (MFR: 40 g/10 min (230°C)) manufactured by Japan Polypropylene Corporation was used. As the scale-like graphite, trade name "CPB-300" (average particle size: 300 um, aspect ratio: 10) manufactured by Chuetsu Graphite Works Co., Ltd. was used. As the oil furnace black of the first carbon black, trade name "EC300J" (BET specific surface area: 800 $m^2$/g, DBP oil absorption amount: 365 ml/100 g, primary particle size: 40 nm) manufactured by Lion Corporation was used. As the oil furnace black of the second carbon black, trade name "VulcanXC72" (BET specific surface area: 254 $m^2$/g, DBP oil absorption amount: 174 ml/100 g, primary particle size: 30 nm) manufactured by Cabot Corporation was used.

Production of resin composition (B-1);

A resin composition (B-1) was obtained according to a pultrusion method by using 60 parts by weight of polypropylene (PP) as the thermoplastic resin and 40 parts by weight of glass fibers having a length of 7 mm. The obtained resin composition (B-1) had a pellet shape and a pellet diameter of 7 mm. As the polypropylene, trade name "MA04A" (MFR: 40 g/10 min (230°C)) manufactured by Japan Polypropylene Corporation was used. As roving fibers (glass fibers), trade name "TUFROV 4520" (fiber diameter: 16 um) manufactured by Nippon Electric Glass Co., Ltd. was used.

The obtained resin composition (A-1) and resin composition (B-1) were dry-blended at a rotation speed of 30 rpm for 5 minutes using a small tumbler at a ratio of 85 : 15 to obtain a resin composition. A resin molded article was obtained in the same manner as in Example 1 except for the above-described points.

(Comparative Example 1)

A resin composition and a resin molded article were obtained in the same manner as in Example 1, except that the content of the plate-like graphite particles was changed to 200 parts by weight, and the first and second carbon blacks were not used.

(Comparative Example 2)

A resin composition and a resin molded article were obtained in the same manner as in Example 1, except that the content of the first carbon black was changed to 40 parts by weight, and the second carbon black was not used.

(Comparative Example 3)

A resin composition and a resin molded article were obtained in the same manner as in Example 1, except that the content of the second carbon black was changed to 40 parts by weight, and the first carbon black was not used.

[Evaluation]

<Volume resistivity>

The volume resistivity of the resin molded article obtained in each of Examples 1 to 9 and Comparative Examples 1 to 3 was measured using a four probe method resistivity measurement device (Product No. "Loresta AX MCP-T370" manufactured by Mitsubishi Chemical Analytech Co., Ltd.).

<Electromagnetic wave shielding effect (dB) at frequency of 3 GHz>

The electromagnetic wave shielding effect (electromagnetic wave shielding performance, unit: dB) at a frequency of 3 GHz of the resin molded article obtained in each of Examples 1 to 9 and Comparative Examples 1 to 3 was measured using a jig for shield property measuring, Dual-Focus Flat Cavity (DFFC) (manufactured by Sanken). Specifically, an electromagnetic wave was radiated from a transmission-side focus, and the intensity of an electromagnetic wave converged to a reception-side focus was measured as a reception voltage. A reception voltage $V_0$ before insertion of a sample and a reception voltage V after insertion of a sample were measured, and the electromagnetic wave shielding effect was calculated according to the following Formula (2).

$$\text{Electromagnetic wave shielding effect} = 20 \times \log_{10}(V_0/V) \ldots \text{Formula (2)}$$

A measurement frequency range was set to 1 GHz to 15 GHz, and as a measuring instrument, Product No. "Component Analyzer N4375D" manufactured by Agilent Technologies, Inc. was used. The sample size of the resin molded article was 300 mm $\times$ 20 mm $\times$ 2.0 mm.

<Spiral flow length>

The fluidity of the resin composition obtained in each of Examples 1 to 9 and Comparative Examples 1 to 3 was evaluated as a spiral flow length. Specifically, the flow length was measured when injection molding was performed at a cylinder temperature of 230°C, a mold temperature of 40°C, and an injection pressure of 150 MPa using a mold for resin flow length measurement having an Archimedes spiral flow path having a width of 20 mm $\times$ a thickness of 2 mm.
Results are shown in Tables 1 and 2 below.

[Table 1]

| | | Example 1 | Example 2 | Example 3 | Example 4 | Example 5 | Example 6 | Example 7 | Example 8 |
|---|---|---|---|---|---|---|---|---|---|
| Thermoplastic resin | Type | Polypropylene | Polypropylene | Polypropylene | Polypropylene | Polypropylene | Polypropylene | Polypropylene | 6-Nylon |
| | Content (parts by weight) | 100 | 100 | 100 | 100 | 100 | 100 | 100 | 100 |
| Graphite | Type | Scale-like graphite | Scale-like graphite | Scale-like graphite | Scale-like graphite | Scale-like graphite | Scale-like graphite | Scale-like graphite | Scale-like graphite |
| | Content (parts by weight) | 150 | 150 | 150 | 150 | 150 | 150 | 150 | 150 |
| | Volume average particle size ($\mu$m) | 80 | 80 | 80 | 80 | 300 | 140 | 80 | 80 |
| First carbon black | Type | Oil furnace black | Oil furnace black | Oil furnace black | Oil furnace black | Oil furnace black | Oil furnace black | Oil furnace black | Oil furnace black |
| | Content (parts by weight) | 20 | 20 | 20 | 20 | 20 | 20 | 20 | 20 |
| | BET specific surface area ($m^2$/g) | 800 | 1052 | 1475 | 800 | 800 | 800 | 800 | 800 |

(continued)

| | | Example 1 | Example 2 | Example 3 | Example 4 | Example 5 | Example 6 | Example 7 | Example 8 |
|---|---|---|---|---|---|---|---|---|---|
| Second carbon black | Type | Oil furnace black | Oil furnace black | Oil furnace black | Oil furnace black | Oil furnace black | Oil furnace black | Oil furnace black | Oil furnace black |
| | Content (parts by weight) | 20 | 20 | 20 | 20 | 20 | 20 | 20 | 20 |
| | BET specific surface area $(m^2/g)$ | 254 | 254 | 254 | 55 | 254 | 254 | 254 | 254 |
| Volume resistivity $(\Omega \cdot cm)$ of molded article | | $1.0 \times 10^{-1}$ | $1.0 \times 10^{-1}$ | $1.0 \times 10^{-1}$ | $1.0 \times 10^{-1}$ | $1.0 \times 10^{-1}$ | $1.0 \times 10^{-1}$ | $1.0 \times 10^{-1}$ | $1.0 \times 10^{-1}$ |
| Electromagnetic wave shielding effect (dB) at frequency of 3 GHz | | 50 | 55 | 60 | 50 | 55 | 55 | 50 | 50 |
| Spiral flow length (mm) | | 250 | 230 | 200 | 300 | 220 | 260 | 260 | 250 |

[Table 2]

| | | | Example 9 | Comparative Example 1 | Comparative Example 2 | Comparative Example 3 |
|---|---|---|---|---|---|---|
| Thermoplastic resin | | Type | Polypropylene | Polypropylene | Polypropylene | Polypropylene |
| | | Content (parts by weight) | 100 | 100 | 100 | 100 |
| Graphite | | Type | Scale-like graphite | Scale-like graphite | Scale-like graphite | Scale-like graphite |
| | | Content (parts by weight) | 160 | 200 | 150 | 150 |
| | | Volume average particle size ($\mu$m) | 300 | 80 | 80 | 80 |
| First carbon black | | Type | Oil furnace black | - | Oil furnace black | |
| | | Content (parts by weight) | 20 | - | 40 | - |
| | | BET specific surface area ($m^2$/g) | 800 | - | 800 | - |
| Second carbon black | | Type | Oil furnace black | - | - | Oil furnace black |
| | | Content (parts by weight) | 20 | - | - | 40 |
| | | BET specific surface area ($m^2$/g) | 254 | - | - | 254 |
| Volume resistivity (Q-cm) of molded article | | | $1.0 \times 10^{-1}$ | $1.0 \times 10^{7}$ | - | $1.0 \times 10^{6}$ |
| Electromagnetic wave shielding effect (dB) at frequency of 3 GHz | | | 48 | 10 | - | 10 |
| Spiral flow length (mm) | | | 280 | 370 | 100 | 330 |

From Tables 1 and 2, it is found that both the electromagnetic wave shielding properties and the moldability are excellent in Examples 1 to 9. On the other hand, in Comparative Examples 1 and 3, the electromagnetic wave shielding properties were not sufficient, and in Comparative Example 2, the moldability was not sufficient.

(Example 10)

Instead of the first carbon black and the second carbon black, 40 parts by weight of oil furnace black (trade name "LIGNITE CB" manufactured by Lion Corporation, BET specific surface area: 1052 $m^2$/g, DBP oil absorption amount: 280 ml/100 g, primary particle size: 41 nm) as the carbon black was used. A resin composition was obtained in the same manner as in Example 9 except for the above-described points.

(Example 11)

Polypropylene (PP) (100 parts by weight) as the thermoplastic resin, scale-like graphite particles (160 parts by weight) as the plate-like graphite particles, and oil furnace black (40 parts by weight) as the carbon black were melt-kneaded at 200°C using Labo Plastomill (Product No. "R100" manufactured by Toyo Seiki Seisakusho, Ltd.) to obtain a resin composition. As the polypropylene, trade name "MA04A" (MFR: 40 g/10 min (230°C)) manufactured by Japan Polypropylene Corporation was used. As the scale-like graphite, trade name "CPB-300" (average particle size: 300 um, aspect ratio: 10) manufactured by Chuetsu Graphite Works Co., Ltd. was used. As the oil furnace black, trade name

**EP 4 282 609 A1**

"LIGNITE CB" (BET specific surface area: 1052 m$^2$/g, DBP oil absorption amount: 280 ml/100 g, primary particle size: 41 nm) manufactured by Lion Corporation was used.

(Example 12)

Production of resin composition (A-2);

Polypropylene (PP) (100 parts by weight) as the thermoplastic resin, scale-like graphite (70 parts by weight) as the plate-like graphite, and 30 parts by weight of oil furnace black as the carbon black were used. These were melt-kneaded at 200°C using Labo Plastomill (Product No. "R100" manufactured by Toyo Seiki Seisakusho, Ltd.) to obtain a resin composition (A-2).

The obtained resin composition (A-2) had a pellet shape and a pellet diameter of 3 mm. The pellet diameter was determined by randomly collecting 100 pellets from a sample and measuring the diameter at the longest point using a caliper. As the polypropylene, trade name "MA04A" (MFR: 40 g/10 min (230°C)) manufactured by Japan Polypropylene Corporation was used. As the scale-like graphite, trade name "CPB-300" (average particle size: 300 um, aspect ratio: 10) manufactured by Chuetsu Graphite Works Co., Ltd. was used. As the oil furnace black, trade name "F-200GS" (BET specific surface area: 55 m$^2$/g, DBP oil absorption amount: 55 ml/100 g, primary particle size: 38 nm) manufactured by Asahi Carbon Co., Ltd. was used.

The obtained resin composition (A-2) and the same resin composition (B-1) as in Example 9 were dry-blended at a rotation speed of 30 rpm for 5 minutes using a small tumbler at a ratio of 70 : 30 to obtain a resin composition.

[Evaluation]

(Pulsed NMR)

For the resin composition obtained in each of Examples 4 and 9 to 12 and Comparative Example 1, the Hahn Echo method was performed at 125°C using pulsed NMR, and the free induction decay curve of the spin-spin relaxation of $^1$H thus obtained was subjected to waveform separation into three curves respectively derived from three components of an S component, an M component, and an L component in ascending order of relaxation time by a least-squares method. The relaxation time of the L component and the ratio (L component/(S component + M component + L component)) of the L component to the sum of the S component, the M component, and the L component were calculated and evaluated according to the following evaluation criteria.

<Evaluation criteria>

Relaxation time of L component;

○... 1.3 msec or less
×... more than 1.3 msec

Ratio (L component/(S component + M component + L component)) (1) ;

○... 10% or less
×... more than 10%

Ratio (L component/(S component + M component + L component)) (2) ;

○... 4% or more
×... less than 4%

The measurement by the Hahn Echo method using the pulsed NMR was performed by the following method.

The resin composition obtained in each of Examples 4 and 9 to 12 and Comparative Example 1 was injection-molded to obtain a resin molded article of 100 mm in length × 100 mm in width × 2 mm in thickness. A flat plate of the obtained resin molded article was cut into 5 mm square to obtain a sample of the resin molded article. Injection molding was performed under conditions of a resin temperature of 230°C, a mold temperature of 50°C, and an injection speed of 30 mm/s.

Into a glass sample tube (Product No. 1824511 manufactured by BRUKER, diameter: 10 mm, length: 180 mm, flat bottom) having a diameter of 10 mm, 700 mg of a sample of the obtained resin molded article was introduced. The

20

sample tube was then placed in a pulsed NMR apparatus ("the minispe mq20" manufactured by BRUKER) and held at 125°C for 10 minutes. Thereafter, the Hahn Echo method was performed at 125°C, and the free induction decay curve of the spin-spin relaxation of $^1$H thus obtained was subjected to waveform separation into three curves respectively derived from three components of an S component, an M component, and an L component in ascending order of relaxation time by a least-squares method.

Waveform separation was performed by fitting using an exponential type. The fitting was performed according to the product manual using analysis software "TD-NMRA (Version 4.3 Rev 0.8)" manufactured by BRUKER.

The following formula was used for fitting.

$$Y = A1 \times \exp(-1 \div w1 \times (t \div T2A)^{w1}) + B1 \times \exp(-1 \div w2 \times (t \div T2B)^{w2}) + C1 \times \exp(-1 \div w3 \times (t \div T2C)^{w3})$$

where w1 to w3 are Weibull coefficients, and w1, w2, and w3 take values of 1. A1 is a component ratio of the S component, B1 is a component ratio of the M component, C1 is a component ratio of the L component, T2A is a relaxation time of the S component, T2B is a relaxation time of the M component, and T2C is a relaxation time of the L component, t is time.

In the Hahn Echo method, the following setting was performed.

Scans: 16times
Recycle Deray: 1sec
First 90-180 Pluse Separation: 0.0082msec
Final Pluse Separation: 5msec
Number of Points for Fitting: 100

Electromagnetic wave shielding properties;

The resin composition obtained in each of Examples 4 and 9 to 12 and Comparative Example 1 was injection-molded to obtain a resin molded article of 100 mm in length × 100 mm in width × 2 mm in thickness, and the resin molded article was used as a measurement sample. Injection molding was performed under conditions of a resin temperature of 230°C, a mold temperature of 50°C, and an injection speed of 30 mm/s.

The electromagnetic wave shielding effect (electromagnetic wave shielding performance, unit: dB) at a frequency of 3 GHz of the obtained resin molded article was measured using a jig for shield property measuring, Dual-Focus Flat Cavity (DFFC) (manufactured by Sanken). Specifically, an electromagnetic wave was radiated from a transmission-side focus, and the intensity of an electromagnetic wave converged to a reception-side focus was measured as a reception voltage. A reception voltage $V_0$ before insertion of a sample and a reception voltage V after insertion of a sample were measured, and the electromagnetic wave shielding effect was calculated according to the following Formula (2).

$$\text{Electromagnetic wave shielding effect} = 20 \times \log_{10}(V_0/V) \ldots \text{Formula (2)}$$

A measurement frequency range was set to 1 GHz to 15 GHz, and as a measuring instrument, Product No. "Component Analyzer N4375D" manufactured by Agilent Technologies, Inc. was used. The sample size of the resin molded article was 100 mm × 100 mm × 2 mm.

Thermal conductivity;

The resin composition obtained in each of Examples 4 and 9 to 12 and Comparative Example 1 was injection-molded to obtain a resin molded article of 100 mm in length × 100 mm in width × 2 mm in thickness, and the resin molded article was used as a measurement sample. Injection molding was performed under conditions of a resin temperature of 230°C, a mold temperature of 50°C, and an injection speed of 30 mm/s.

The thermal conductivity (thermal conductivity in the in-plane direction and the thickness direction) of the obtained measurement sample was measured using Product No. "Xenon Flash Laser Analyzer LFA 467 HyperFlash" manufactured by NETZSCH Japan K.K. Specifically, the measurement sample was fitted into a holder in a direction in which the thermal conductivity can be measured, the thermal diffusivity at 30°C was measured, and the thermal conductivity was calculated according to the following Formula (1).

$$\text{Thermal conductivity } (W/(m \cdot K)) = \text{Specific gravity } (g/cm^3) \times$$

$$\text{Specific heat } (J/g \cdot K) \times \text{Thermal diffusivity } (mm^2/s) \ldots \text{ Formula (1)}$$

Long-term heat resistance;

The resin composition obtained in each of Examples 4 and 9 to 12 and Comparative Example 1 was injection-molded to obtain a dumbbell-shaped test piece conforming to ISO 527. Injection molding was performed under conditions of a resin temperature of 230°C, a mold temperature of 50°C, and an injection speed of 30 mm/s.

The obtained test piece was exposed to each of thermostatic baths under atmospheres of 23°C and 125°C for 3,000 hours, the test piece left to stand under an atmosphere of 23°C was defined as a test piece before heat deterioration resistance, the test piece left to stand under an atmosphere of 125°C was defined as a test piece after heat deterioration resistance, and these test pieces were used as measurement samples. A tensile test was performed in accordance with ISO 527 to measure a tensile strength. The long-term heat resistance was calculated according to the following Formula (2).

$$\text{Long-term heat resistance } (\%) = \text{Tensile strength } (MPa) \text{ after}$$

$$\text{heat deterioration resistance/Tensile strength } (MPa) \text{ before heat}$$

$$\text{deterioration resistance} \ldots \text{ Formula (2)}$$

Results are shown in Table 3.

[Table 3]

| | | Example 4 | Example 9 | Example 10 | Example 11 | Example 12 | Comparative Example 1 |
|---|---|---|---|---|---|---|---|
| Pulsed NMR | Relaxation time of L component | ○ | ○ | ○ | ○ | ○ | × |
| | Ratio (L component/(S component + M component + L component)) (1) | ○ | ○ | ○ | ○ | ○ | × |
| | Ratio (L component/(S component + M component + L component)) (2) | ○ | ○ | ○ | ○ | ○ | × |
| Thermal conductivity (W/ (m·K)) | In-plane direction | 19 | 16 | 17 | 20 | 5 | 19 |
| | Thickness direction | 3 | 3 | 3 | 3 | 1 | 3 |
| Electromagnetic wave shielding effect (dB) at frequency of 3 GHz | | 50 | 48 | 45 | 47 | 60 | 10 |
| Long-term heat resistance | | 82 | 85 | 87 | 83 | 80 | 65 |

**Claims**

1. A resin composition comprising:

   a thermoplastic resin (A);
   graphite (B); and
   two or more kinds of carbon black (C),
   the two or more kinds of carbon black (C) including a first carbon black (C-1) having a BET specific surface area of 600 $m^2$/g or more and a second carbon black (C-2) having a BET specific surface area of less than 600 $m^2$/g.

2. The resin composition according to claim 1, wherein with respect to 100 parts by weight of the thermoplastic resin (A),

   a content of the first carbon black (C-1) is 5 parts by weight or more and 50 parts by weight or less,
   a content of the second carbon black (C-2) is 5 parts by weight or more and 50 parts by weight or less, and
   a content of the entire carbon black (C) is 15 parts by weight or more and 90 parts by weight or less.

3. The resin composition according to claim 1 or 2, wherein a DBP oil absorption amount of the first carbon black (C-1) is 250 ml/100 g or more, and
   a DBP oil absorption amount of the second carbon black (C-2) is less than 250 ml/100 g.

4. The resin composition according to any one of claims 1 to 3, wherein an ash content of each of the two or more kinds of carbon black (C) is 1% or less.

5. The resin composition according to any one of claims 1 to 4, wherein the graphite (B) is plate-like graphite.

6. The resin composition according to any one of claims 1 to 5, wherein a volume average particle size of the graphite (B) is 5 um or more and 500 um or less.

7. The resin composition according to any one of claims 1 to 6, wherein a content of the graphite (B) is 50 parts by weight or more and 300 parts by weight or less with respect to 100 parts by weight of the thermoplastic resin (A).

8. The resin composition according to any one of claims 1 to 7, wherein the thermoplastic resin (A) is at least one resin of an olefin-based resin and a nylon-based resin.

9. The resin composition according to any one of claims 1 to 8, wherein a specific volume resistivity is $1.0 \times 10^5$ Ω·cm or less.

10. A resin composition comprising:

    a thermoplastic resin (A);
    graphite (B); and
    carbon black (D),
    when the resin composition in a molten state is filled in a mold from a direction orthogonal to a thickness direction of a resulting resin molded article and molded to obtain a resin molded article of 100 mm in length $\times$ 100 mm in width $\times$ 2 mm in thickness,
    a relaxation time of an L component being 1.3 msec or less when a free induction decay curve of spin-spin relaxation of $^1$H obtained by measuring the resin molded article using pulsed NMR at 125°C by Hahn Echo method is subjected to waveform separation into three curves respectively derived from three components of an S component, an M component, and an L component in ascending order of relaxation time by a least-squares method.

11. The resin composition according to claim 10, wherein a ratio (L component/(S component + M component + L component)) of the L component to a sum of the S component, the M component, and the L component is 10% or less.

12. The resin composition according to claim 10 or 11, wherein a ratio (L component/(S component + M component + L component)) of the L component to a sum of the S component, the M component, and the L component is 4% or more.

**13.** The resin composition according to any one of claims 10 to 12, wherein the graphite (B) is plate-like graphite.

**14.** The resin composition according to any one of claims 10 to 13, wherein the thermoplastic resin (A) includes an olefin-based resin.

**15.** The resin composition according to any one of claims 1 to 14, wherein when the resin composition in a molten state is filled in a mold from a direction orthogonal to a thickness direction of a resulting resin molded article and molded to obtain a resin molded article of 100 mm in length × 100 mm in width × 2 mm in thickness, an electromagnetic wave shielding effect of the resin molded article at a frequency of any of 3 GHz, 25 GHz, 50 GHz, and 75 GHz is 20 dB or more.

**16.** The resin composition according to any one of claims 1 to 15, wherein when the resin composition in a molten state is filled in a mold from a direction orthogonal to a thickness direction of a resulting resin molded article and molded to obtain a resin molded article of 100 mm in length × 100 mm in width × 2 mm in thickness, a thermal conductivity in an in-plane direction of the resin molded article is 1 W/(m·K) or more.

**17.** A resin molded article being a molded article of the resin composition according to any one of claims 1 to 16.

**18.** The resin molded article according to claim 17, comprising a fiber.

**19.** The resin molded article according to claim 17 or 18, wherein a specific volume resistivity is $1.0 \times 10^5$ Ω·cm or less.

**20.** A method for producing a resin molded article, comprising:

a step of mixing the resin composition according to any one of claims 1 to 16 and a composite body (E) containing a thermoplastic resin and a fiber to obtain a mixture; and
a step of molding the mixture to obtain a resin molded article.

[FIG. 1.]

A

[FIG. 2.]

B

[FIG. 3.]

C

## INTERNATIONAL SEARCH REPORT

International application No.

**PCT/JP2022/002549**

### A. CLASSIFICATION OF SUBJECT MATTER

**B29B 15/10**(2006.01)i; **B29C 45/00**(2006.01)i; **C08J 3/20**(2006.01)i; **C08K 7/02**(2006.01)i; **C08K 7/04**(2006.01)i; **C08L 23/00**(2006.01)i; **C08L 77/00**(2006.01)i; **C08L 101/00**(2006.01)i; **C08J 5/00**(2006.01)i; **B29C 70/06**(2006.01)i; **B29C 70/42**(2006.01)i; **C08K 3/013**(2018.01)i; **C08K 3/04**(2006.01)i

FI: C08L101/00; C08K3/04; C08K7/04; C08L23/00; B29C45/00; B29B15/10; B29C70/06; B29C70/42; C08L77/00; C08J5/00 CFG; C08K3/013; C08K7/02; C08J3/20 B CER; C08J3/20 CES

According to International Patent Classification (IPC) or to both national classification and IPC

### B. FIELDS SEARCHED

Minimum documentation searched (classification system followed by classification symbols)

B29B15/10; B29C45/00; C08J3/20; C08K7/02; C08K7/04; C08L23/00; C08L77/00; C08L101/00; C08J5/00; B29C70/06; B29C70/42; C08K3/013; C08K3/04

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2012-97213 A (NOK CORP.) 24 May 2012 (2012-05-24) example 1, etc. | 1-5, 9-13, 15-17, 19-20 |
| A | | 6-8, 14, 18 |
| X | WO 2015/005081 A1 (NOK CORP.) 15 January 2015 (2015-01-15) example 1, etc. | 1-5, 9-13, 15-17, 19-20 |
| A | | 6-8, 14, 18 |
| X | WO 2015/005080 A1 (NOK CORP.) 15 January 2015 (2015-01-15) example 1, etc. | 1-5, 9-13, 15-17, 19-20 |
| A | | 6-8, 14, 18 |
| A | JP 2018-123266 A (THE FURUKAWA ELECTRIC CO., LTD.) 09 August 2018 (2018-08-09) paragraph [0088] | 1-20 |

☑ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **06 April 2022** | **19 April 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

| International application No. |
| --- |
| **PCT/JP2022/002549** |

**C.    DOCUMENTS CONSIDERED TO BE RELEVANT**

| Category* | Citation of document, with indication, where appropriate, of the relevant passages | Relevant to claim No. |
| --- | --- | --- |
| A | 飯島孝ほか, 種々のカーボンブラックの固体高分子形燃料電池用触媒担体への適用-1, 電池討論会講演要旨集, 今西誠之 (公社) 電気化学会 電池技術委員会, 2015, page 175, non-official translation (IIJIMA, Takashi et al. Application of various carbon blacks to catalyst carriers for solid polymer electrolyte fuel cells - 1. Battery debate lecture abstracts. IMANISHI, Nobuyuki. (Public Interest Incorporated Association.) Electrochemical Society. Battery Technical Committee.)<br>    table 1, etc. | 1-20 |
| A | WO 2018/199008 A1 (SEKISUI TECHNO MOLDING CO., LTD.) 01 November 2018 (2018-11-01) | 1-20 |
| A | JP 2003-258491 A (NITTA IND. CORP.) 12 September 2003 (2003-09-12) | 1-20 |
| A | JP 2019-167521 A (SEKISUI TECHNO MOLDING CO., LTD.) 03 October 2019 (2019-10-03) | 1-20 |
| A | JP 2019-176143 A (SEKISUI TECHNO MOLDING CO., LTD.) 10 October 2019 (2019-10-10) | 1-20 |
| A | JP 60-042461 A (SUMITOMO BAKELITE KK) 06 March 1985 (1985-03-06) | 1-20 |
| A | CN 102993577 A (NANJING YATONG RUBBER PLASTICS COMPANY LTD.) 27 March 2013 (2013-03-27) | 1-20 |

Form PCT/ISA/210 (second sheet) (January 2015)

**INTERNATIONAL SEARCH REPORT**
Information on patent family members

International application No.

**PCT/JP2022/002549**

| Patent document cited in search report | | | Publication date (day/month/year) | Patent family member(s) | | | Publication date (day/month/year) |
|---|---|---|---|---|---|---|---|
| JP | 2012-97213 | A | 24 May 2012 | (Family: none) | | | |
| WO | 2015/005081 | A1 | 15 January 2015 | US example 1, etc. EP CN | 2016/0152790 3020758 105555857 | A1 A1 A | |
| WO | 2015/005080 | A1 | 15 January 2015 | US example 1, etc. EP CN | 2016/0152789 3020757 105392834 | A1 A1 A | |
| JP | 2018-123266 | A | 09 August 2018 | (Family: none) | | | |
| WO | 2018/199008 | A1 | 01 November 2018 | US EP CN KR | 2021/0108047 3617274 110198989 10-2019-0138769 | A1 A1 A A | |
| JP | 2003-258491 | A | 12 September 2003 | (Family: none) | | | |
| JP | 2019-167521 | A | 03 October 2019 | (Family: none) | | | |
| JP | 2019-176143 | A | 10 October 2019 | (Family: none) | | | |
| JP | 60-042461 | A | 06 March 1985 | (Family: none) | | | |
| CN | 102993577 | A | 27 March 2013 | (Family: none) | | | |

Form PCT/ISA/210 (patent family annex) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018143224 A
- JP 2018002983 A